# EUROPEAN PATENT APPLICATION

(11) **EP 2 653 775 A1**
(43) Date of publication of application: **23.10.2013**
(21) Application number: 12164357.1
(22) Date of filing: 17.04.2012
(51) Int. Cl.: F21S 2/00, F21V 9/16, F21V 33/00, C09K 11/00, E04B 9/00, G10K 11/00, F21Y 101/02, F21Y 105/00, F21W 121/00

(54) **Acoustic light emitting element**

(71) Applicant: Koninklijke Philips N.V., 5656 AE Eindhoven (NL)
(72) Inventor: Hikmet, Rifat, A.,M., 5600 AE Eindhoven (NL); Van Bommel, Ties, 5600 AE Eindhoven (NL); Yu, Joan, H., 5600 AE Eindhoven (NL)
(74) Representative: Damen, Daniel Martijn

(57) **Abstract**

A wavelength converting member (103) comprises a wavelength converting material (105), capable of converting light of a first wavelength range into light of a second wavelength range, said wavelength converting material being dispersed in an acoustic material (104). The wavelength converting member may form an acoustic panel, and may be used in a light emitting arrangement (100, 120, 140) comprising: a solid state light source (101) adapted to emit light of a first wavelength range; and the wavelength converting member (103), arranged to receive light of said first wavelength range emitted by the light source. Thus, sound-damping and light emitting properties may be combined in a single panel. The invention also provides a luminaire (130) combining light-emitting and sound-damping properties.

## Description

### FIELD OF THE INVENTION

The invention relates to light-emitting arrangements and panels useful as building materials.

### BACKGROUND OF THE INVENTION

Semiconductor-based based illumination devices are increasingly used for a wide variety of lighting applications, including general and decorative lighting applications. Light-emitting diodes (LEDs) offer advantages over traditional light sources, such as incandescent and fluorescent lamps, including long lifetime, high lumen efficacy, low operating voltage and fast modulation of lumen output. Efficient high-power LEDs are often based on blue light emitting materials. To produce an LED based illumination device having a desired color (e.g., white) output, a suitable wavelength converting material, commonly known as a phosphor, may be used which converts part of the light emitted by the LED into light of longer wavelengths so as to produce white light. For instance, the light source may comprise a blue LED with one or more phosphor materials to provide white light.

The use of LEDs incorporated into translucent or transparent material to produce light emitting surfaces, e.g. for walls, ceiling or floors, have previously been suggested. For example, US 7,543,956 describes methods and means for embedding electronic components, such as LED-based light sources, into molded or continuously cast surface materials, to provide lighted finish surfaces.

However, there remains a need for further improved light emitting surfaces and panels which can be used for building materials or interior decoration.

### SUMMARY OF THE INVENTION

It is an object of the present invention to overcome this problem, and to provide a panel which combines light emission or at least light conversion with sound damping properties.

According to a first aspect of the invention, this and other objects are achieved by a wavelength converting member comprising a wavelength converting material, capable of converting light of a first wavelength range into light of a second wavelength range, said wavelength converting material being dispersed in an acoustic material. Typically, said wavelength converting material is contained within a layer of acoustic material.

Hence a wavelength converting member according to the invention may form, or form part of (e.g. a layer) of an acoustic panel, which may be provided an interior wall panel or a ceiling panel and combined with a light source to provide a light emitting, acoustic panel.

The acoustic material at least does not reflect acoustic waves, and may preferably absorb acoustic waves. The acoustic material may be porous or fibrous. In embodiments of the invention, the acoustic material is selected from chalk, acoustic foams, natural mineral fibers, and synthetic mineral fibers. In particular, the acoustic material may comprise chalk. Chalk is cheap and has suitable optical properties, in addition to its acoustic properties.

In a further aspect, the invention relates to a light emitting arrangement comprising:
- a solid state light source adapted to emit light of a first wavelength range; and
- a wavelength converting member as described above arranged to receive light of said first wavelength range emitted by the light source.

In embodiments of the invention, the solid state light source and the wavelength converting material are mutually spaced apart.

In embodiments of the invention the light emitting arrangement further comprises a diffusive layer arranged in the light output direction from the wavelength converting member. Hence, light distribution may be improved. Optionally the diffusive layer may comprise an acoustic material, such as chalk, in which case the sound damping or sound absorbing properties of the light emitting arrangement may be further improved.

In some embodiments, the solid state light source may be covered by the acoustic material. In alternative embodiments, the solid state light source is not enclosed by the acoustic material. For example, in some embodiments the wavelength converting member may form a panel or part of a panel, typically the surface of a panel, and the solid state light source may be arranged on an external surface of said panel, or may be adapted to be suspended in front of said panel to emit light in the direction of the panel. Arranging the light source on an external surface may simplify production, mounting and/or maintenance of the light emitting panel. Using a light source arranged at a distance from a wavelength converting acoustic panel also simplifies production of the acoustic panel, and may avoid problems related to heat management.

In another aspect, the invention provides a luminaire comprising a light emitting arrangement as described herein. In one embodiment, a luminaire may for example comprise a frame and at least one solid state light source may be arranged on an inner surface of said frame. The luminaire combines light-emitting and sound-damping properties.

In further aspects, the invention relates to the use of a wavelength converting member as described herein, or a light emitting arrangement as described herein, as a building material.

It is noted that the invention relates to all possible combinations of features recited in the claims.

### BRIEF DESCRIPTION OF THE DRAWINGS

This and other aspects of the present invention will now be described in more detail, with reference to the appended drawings showing embodiment(s) of the invention.
Fig. 1 is a cross-sectional side view of a light emitting arrangement according to embodiments of the invention, in which a light source is covered by a wavelength converting member.
Fig. 2 is a cross-sectional side view of a light emitting arrangement according to other embodiments of the invention, further comprising a diffusive layer.
Fig. 3 is a cross-sectional side view of a light emitting arrangement according to other embodiments of the invention, in which a light source is arranged on an external surface of a wavelength converting member.
Fig. 4 is a cross-sectional side view of a light emitting arrangement according to other embodiments of the invention, in which a plurality of light sources are suspended in front of a wavelength converting member.
Fig. 5 is a cross-sectional side view of a light emitting arrangement according to other embodiments of the invention, in which a light source is arranged at a distance from the wavelength converting member.
Fig. 6 is a cross-sectional side view of a light emitting arrangement according to other embodiments of the invention in which a light source is arranged at a distance from the wavelength converting member.
Fig. 7 is a cross-sectional side view of a light emitting arrangement according to other embodiments of the invention comprising two wavelength converting members.
Fig. 8 is a cross-sectional side view of a light emitting arrangement according to other embodiments of the invention in which the wavelength converting member comprises distinct regions having different wavelength converting characteristics.
Fig. 9 is a cross-sectional side view of a light emitting arrangement according to other embodiments of the invention in which the wavelength converting member comprises particles of a material having high thermal conductivity.
Fig. 10 is a perspective view of a light-emitting arrangement forming a light-emitting acoustic panel, according to embodiments of the invention.
Fig. 11a is a perspective view of a luminaire comprising a light emitting arrangement according to embodiments of the invention.
Fig. 11b is a partial, cross-sectional side view of a luminaire comprising a light emitting arrangement according to embodiments of the invention.
Fig. 12a is a cross-sectional side view of a light-emitting arrangement according to embodiments of the invention.
Fig. 12b is a perspective view of a ceiling comprising the light-emitting arrangement of Fig. 12a.

As illustrated in the figures, the sizes of layers and regions are exaggerated for illustrative purposes and, thus, are provided to illustrate the general structures of embodiments of the present invention. Like reference numerals refer to like elements throughout.

### DETAILED DESCRIPTION

The present invention will now be described more fully hereinafter with reference to the accompanying drawings, in which currently preferred embodiments of the invention are shown. This invention may, however, be embodied in many different forms and should not be construed as limited to the embodiments set forth herein; rather, these embodiments are provided for thoroughness and completeness, and fully convey the scope of the invention to the skilled person.

As used herein, "acoustic material" means a material which does not reflect acoustic waves. In contrast, an acoustic material may absorb acoustic waves. For example, an acoustic material may be a porous or fibrous material. Acoustic materials are typically used for sound-damping and soundproofing, and may be formed into or form part of a building panel, such as a wall panel, ceiling panel, etc. Hence, an "acoustic element" or "acoustic panel" is an element or a panel, respectively, which contains an acoustic material. Typically such an element or panel has a surface comprising the acoustic material.

It may be noted that the surface material CORIAN^{®} suggested in US 7,543,956, which is a composite material of plexiglass (poly methyl methacrylate, PMMA) filled with titanium oxide particles, is a good sound reflector and thus is not an acoustic material within the meaning defined above.

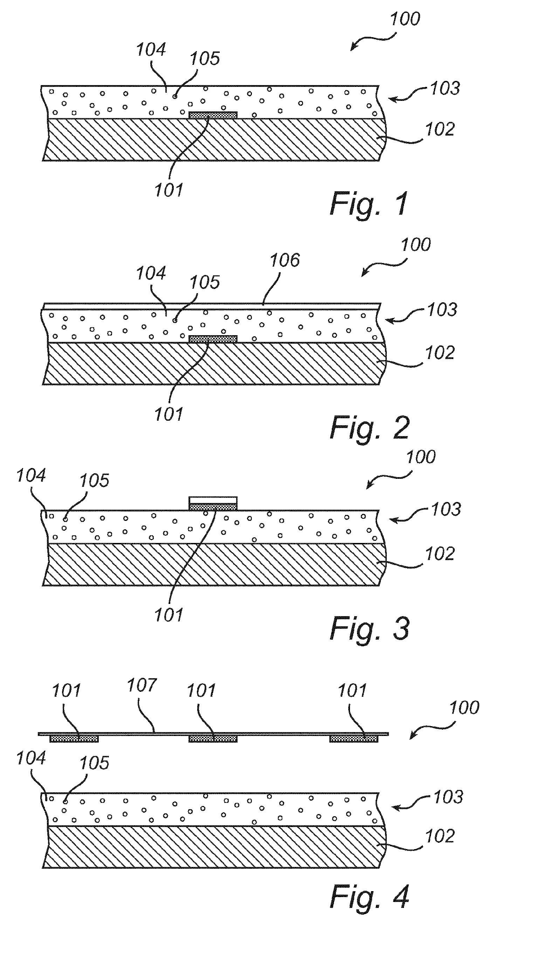

Fig. 1 illustrates a light emitting arrangement 100 comprising a wavelength converting member according to embodiments of the invention. A solid state light source 101, here a light emitting diode (LED) is arranged on a support layer 102 and connected by conventional means to drive electronics (not shown). The LED 101 is covered with a wavelength converting member 103 in the form of a cover layer. The wavelength converting member 103 comprises an acoustic material 104, such as chalk. A wavelength converting material 105, capable of converting the primary light emitted by the light source into secondary light, is dispersed in the acoustic material 104. The acoustic material is at least partly translucent, in order to allow at least secondary light emitted by the wavelength converting material to exit from the wavelength converting member.

The support layer 102 on which the LED 101 is arranged may optionally comprise an acoustic material, typically the same acoustic material as the wavelength converting member 103. In such embodiments, the light source may thus be completely embedded in acoustic material. In another embodiment of the invention, the solid state light source 101 may be covered by a dome or a protective layer, physically separating the solid state light source from the acoustic material and the wavelength converting material.

In an embodiment of the invention illustrated in Fig. 2, a scattering layer 106 may be provided on the wavelength converting member 103. The diffusive layer 106 preferably also comprises an acoustic material, optionally the same as the wavelength converting member. In some embodiments, the diffusive layer 106 may comprise a textile.

In another embodiment of the invention, illustrated in Fig. 3, a light emitting arrangement 100 comprises a wavelength converting member 103, optionally arranged on a support layer 102 which may be as described above. A solid state light source 101, here a side-emitter LED, is arranged on an external surface of the wavelength converting member and is adapted to emit light into the wavelength converting layer.

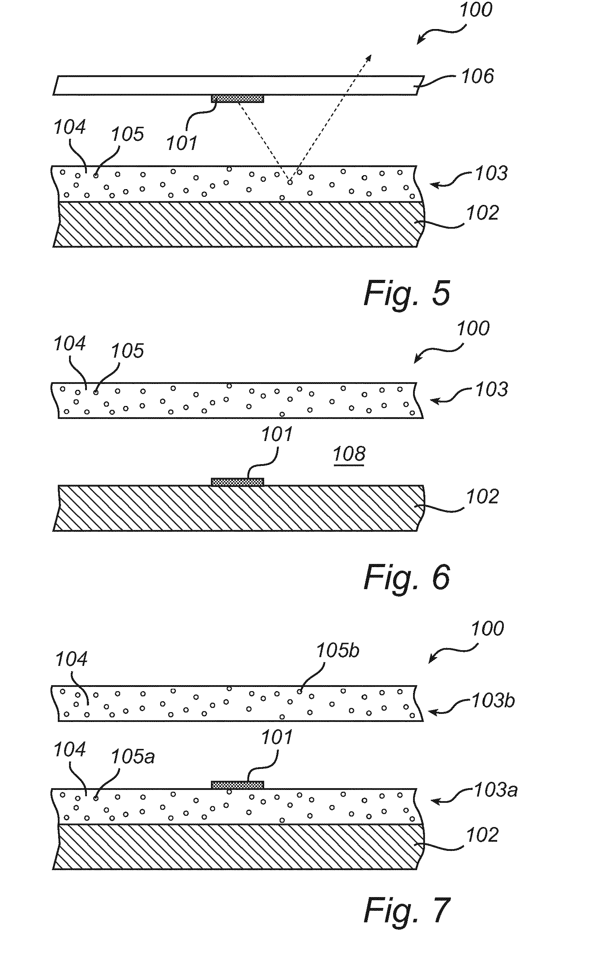

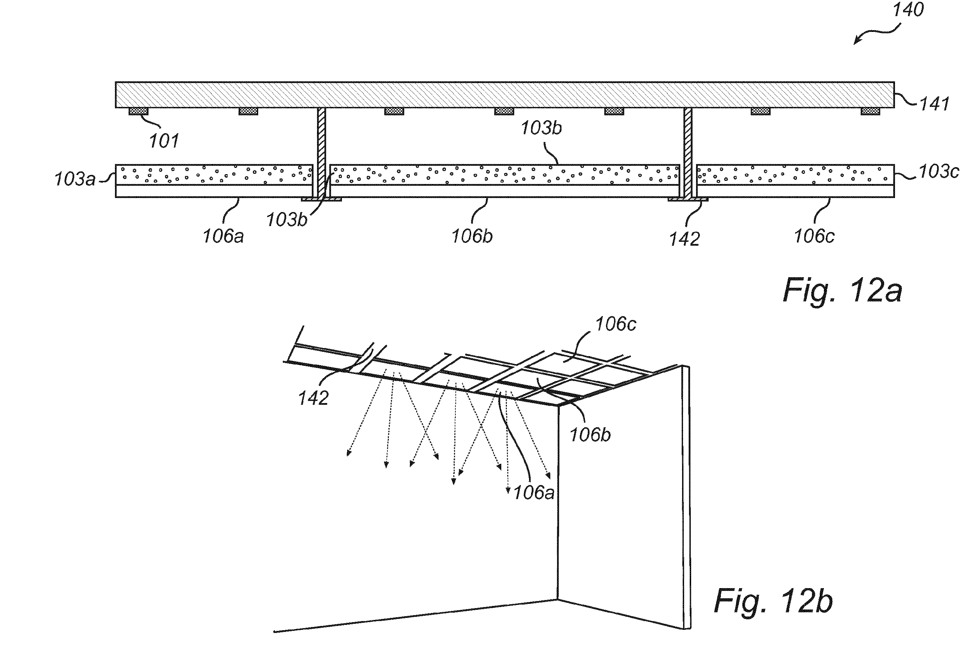

Fig. 4 illustrates another embodiment of a light emitting arrangement 100 wherein a plurality of solid state light sources 101 is arranged at a distance from the wavelength converting member 103 and directed to emit light in the direction of the wavelength converting member. As illustrated in Fig. 4, the solid state light sources may be attached to a frame 107 suspended in front of the wavelength converting member. The frame 107 may for example be a chickenwire or a lead frame. Alternatively, as illustrated in Fig. 5, the solid state light source(s) 101 may be arranged on a diffusive layer 106 arranged at a distance, in the light output direction, from the wavelength converting member 103. Alternatively, in other embodiments described in further detail below with reference to Fig. 12a, the solid state light source may be arranged on a support and the wavelength converting member may be suspended in front of the solid state light source.

Thus, as shown in Figs. 4 and 5, the wavelength converting member, optionally arranged on a support 102, may form a separate body, typically an acoustic panel, in front of which one or more solid state light sources may be arranged to emit primary light in the direction of the panel.

In yet another embodiment, illustrated in Fig. 6, a solid state light source 101 is arranged on the support layer 102. The wavelength converting member 103 is arranged at a distance from the solid state light source 101, separated for example by an air gap (108), or by an optical coupling material. In embodiments, the solid state light source ant the wavelength converting member may be separated by a light guide.

In embodiments of the invention a light emitting arrangement may comprise more than one wavelength converting member. For example, as illustrated in Fig. 7, a solid state light source 101 may be arranged on a first wavelength converting member 103a and optionally a support layer 102. In contrast to the embodiment shown in Fig. 3, the solid state light source 101 of Fig. 7 is adapted to emit light away from the wavelength converting member 103a. A second wavelength converting member 103b is provided in the light output direction from the solid state light source 101. The second wavelength converting member 103b receives light emitting by the solid state light source and converts part of this light into secondary light. Primary light that is not converted by the second wavelength converting member 103b is scattered in all directions, and may thus be received and converted by the first wavelength converting member 103a.

The acoustic material used in the present invention may be an acoustic material. Typically an acoustic material used in the present invention has a certain degree of porosity. Importantly, the wavelength converting member should be at least partly transmissive or translucent. If the acoustic material is not transmissive, typically the content of the acoustic material in the wavelength converting member, or the thickness of the wavelength converting member, may be adapted with regard to this requirement.

Examples of acoustic materials include chalk, acoustic foams, natural mineral fibers, or synthetic mineral fibers made from natural or synthetic minerals or metal oxide. "Acoustic foams" refer to open celled foams e.g. made of polyurethane, fiber glass or melamine. "Synthetic mineral fibers" refer to fibrous inorganic substances made primarily from rock, clay, slag, or glass. Synthetic mineral fibers include fiber glass (glass wool and glass filament), ceramic fibers and stone wool. Preferably the acoustic material is chalk. Chalk is a soft, white, porous limestone, composed of calcite (CaCO₃). When chalk is used in the present invention it may be provided as a powder, mixed with the wavelength converting material, and subsequently formed into a layer, optionally on a support, or a panel.

The wavelength converting material used in the present invention may be an inorganic phosphor material, an organic phosphor material, or quantum dots. The wavelength converting material is typically selected with respect to the intended function of the light emitting arrangement, e.g. general illumination, decorative illumination etc. In embodiments of the invention the light emitting arrangement may emit white light. However, any desirable spectral composition of light may be obtained by suitably selecting the solid state light source(s) and the wavelength converting material(s). For example, in embodiments of the invention, a wavelength converting member 103, 103a, 103b may comprise a plurality of wavelength converting materials. Two or more wavelength converting materials may be contained in a single wavelength converting layer, dispersed in the acoustic material. In other embodiments, different wavelength converting materials may be contained in separate layers, each wavelength converting material dispersed in the acoustic material.

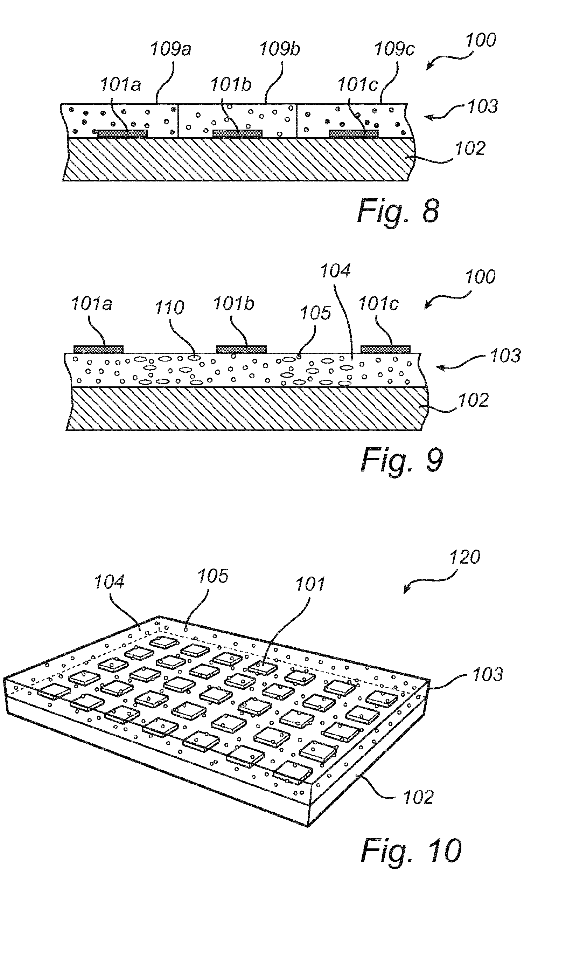

In some embodiments, illustrated in Fig. 8, a light emitting arrangement comprises a plurality of light sources 101a, 101b, 101c, each light source associated with a distinct region 109a, 109b, 109c of the wavelength converting member, typically covered by the respective region. Adjacent regions 109a, 109b may comprise different wavelength converting materials, different concentrations or amounts of the same wavelength converting material, or have different wavelength converting characteristic for other reasons. Such wavelength converting regions may produce decorative lighting effects.

In other embodiments of the invention, the wavelength converting member may have a concentration gradient of wavelength converting material, with the highest concentration in a region of the wavelength converting member to be arranged closest to a solid state light source.

Examples of inorganic phosphor materials include, but are not limited to, cerium (Ce) doped YAG (Y₃Al₅O₁₂) or LuAG (Lu₃Al₅O₁₂). Ce doped YAG emits yellowish light, whereas Ce doped LuAG emits yellow-greenish light. Examples of other inorganic phosphors materials which emit red light may include, but are not limited to ECAS and BSSN; ECAS being Ca₁₋ₓAlSiN₃:Euₓ wherein 0<x≤1, preferably 0<x:≤0.2; and BSSN being Ba_{2-x-z}MₓSi_{5-y}Al_{y}N_{8-y}O_{y}:Eu_{z} wherein M represents Sr or Ca, 0<x≤1, 0≤y≤4, and 0.0005≤z≤0.05, and preferably 0≤x≤0.2). Examples of suitable organic phosphor materials are organic luminescent materials based on perylene derivatives, for example compounds sold under the name Lumogen^{®} by BASF. Examples of suitable compounds include, but are not limited to, Lumogen^{®} Red F305, Lumogen^{®} Orange F240, Lumogen^{®} Yellow F083, and Lumogen^{®} F 170.

In some embodiments, the wavelength converting material may be quantum dots or quantum rods. Quantum dots are small crystals of semiconducting material generally having a width or diameter of only a few nanometers. When excited by incident light, a quantum dot emits light of a color determined by the size and material of the crystal. Light of a particular color can therefore be produced by adapting the size of the dots. Most known quantum dots with emission in the visible range are based on cadmium selenide (CdSe) with shell such as cadmium sulfide (CdS) and zinc sulfide (ZnS). Cadmium free quantum dots such as indium phosphode (InP), and copper indium sulfide (CuInS₂) and/or silver indium sulfide (AgInS₂) can also be used. Quantum dots show very narrow emission band and thus they show saturated colors. Furthermore the emission color can easily be tuned by adapting the size of the quantum dots. Any type of quantum dot known in the art may be used in the present invention. However, it may be preferred for reasons of environmental safety and concern to use cadmium-free quantum dots or at least quantum dots having a very low cadmium content.

In a further embodiment of the present invention, the wavelength converting member 103 may contain transparent elements, such as particles, rods or fibers of transparent material. Examples of suitable transparent materials include glass, aluminium oxide and transparent polymers. For instance, the wavelength converting member may comprise glass particles or glass rods, aluminium oxide particles, or polymer particles or polymer fibers. The incorporation of the transparent elements into the wavelength converting member may increase transparency.

The solid state light source used in the light emitting arrangement may be a light emitting diode (LED), an organic light emitting diode (OLED) or a laser diode. In some embodiments the solid state light source is a blue light emitting LED, such as GaN or InGaN based LED, preferably emitting primary light in the range of from 440 to 460 nm. Alternatively, the solid state light source may emit UV or violet light which is subsequently converted into light of longer wavelength(s) by one or more wavelength converting materials.

In yet another embodiment, illustrated in Fig. 9, the wavelength converting member 103 may comprise particles 110 of a material having high thermal conductivity and/or high reflectivity. The particles 110 are typically dispersed in the acoustic material. One example is particles of boron nitride. Particles of a highly thermally conductive material may improve the thermal conductivity of the wavelength converting member 103 as a whole, reducing the risk for overheating of the wavelength converting material 105 and/or the solid state light source 101 during operation thereof. Preferably the particles 110 may be unevenly distributed in the wavelength converting member, contained at higher concentrations in regions in between the solid state light sources, and at lower concentrations in regions of the wavelength converting member arranged directly in front of the solid state light sources. The thermal conductivity and/or the reflectivity of the wavelength converting member may thus be locally improved, without obstructing the path of light from the light source to the wavelength converting material and/or the emission from the wavelength converting material. Increased reflectivity of portions in between the light sources may increase the efficiency of the light emitting arrangement.

The wavelength converting member may be used as an acoustic building material, for example a wall panel or a ceiling panel. In particular, such a panel may be a light emitting panel, comprising a plurality of solid state light sources as described above. Fig. 10 shows an acoustic light-emitting panel 120 according to embodiments of the invention, comprising a plurality of solid state light sources 101 arranged on a substrate 102 and covered by an acoustic wavelength converting member 103. Typically, the acoustic panel may be arranged to face the interior of a room or building. It is however also contemplated that a acoustic panel comprising the wavelength converting member 103 may be arranged on the exterior of a building, e.g. on an exterior wall.

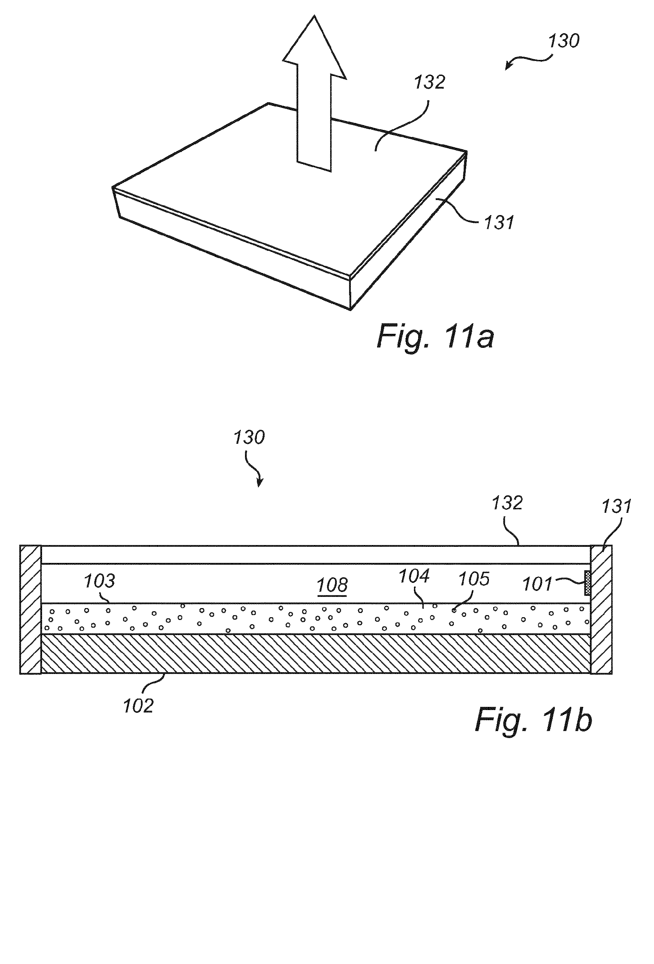

Alternatively, the wavelength converting member of the invention may be used in a lamp or luminaire where also sound damping properties are desired, for example for open plan environments, office cubicles etc. Fig. 11a shows an example of a luminaire 130, comprising a frame 131 and a light exit window 132 e.g. in the form of a transparent or translucent plate. The arrow represents the general direction of light emission. Fig. 11b shows an example of a luminaire 130 in cross-section. The support 102 forms a bottom portion of the luminaire, and the light exit window 132 forms a top portion. The frame 131 connects the top and bottom portions, and may define the periphery of the light exit window. Optionally the frame 131 may form at least part of the bottom portion, such that the support 102 is mounted on or supported by a parallel portion of the frame 131. Although the luminaire is described using the terms "top" and "bottom", it is envisaged that the luminaire could be arranged in any direction, with the light exit window facing upwards or downwards, or to a side, e.g. when the luminaire is mounted on a wall, with the support 102 facing the wall. Alternatively, the luminaire may be adapted to be suspended e.g. from a ceiling.

Inside the luminaire 130, at least one light source 101, typically an LED, is arranged on an inner surface of the frame 131. Optionally a plurality of light sources may be used, evenly distributed along the inside of the frame or arranged only on certain portions, e.g. two opposite portions, of the frame. The wavelength converting member 103 comprising the acoustic material 104 and wavelength converting material 105 is provided on the support 102. Light emitted by the light source 101 is received by the wavelength converting member, and is emitted generally in the direction of the light exit window. Optionally, the inner surface of the frame 131 may be reflective.

The light exit window 132 is at least partly transparent to allow light to exit from the luminaire. Optionally the light exit window may be diffusing. In some embodiments, also the light exit window comprises an acoustic material.

Fig. 12a illustrates another light emitting arrangement that can be mounted in a ceiling, so as to provide an acoustic, light emitting ceiling. The light emitting arrangement 140 comprises a plurality of solid state light sources 101, typically LEDs, mounted on a carrier 141 to emit light downwards. The carrier 141 may be a ceiling. Wavelength converting members 103a, 103b, 103c are arranged in front of (i.e., in the light emitting direction) and underneath the light sources 101, supported by a support member 142 in the form of a grid frame. Instead of a grid frame, a plurality of individual support members, e.g. support bars, may be used.

Each wavelength converting member 103a, 103b, 103c is arranged to receive light from a plurality of light sources, and the total number of light sources used may thus exceed the number of wavelength converting members. Diffusive layers 106a, 106b, 106c is arranged on each respective wavelength converting member 103a, 103b, 103c on a light exit side thereof. The diffusive layers 106a, 106b 106c may be as the diffusive layer 106 described above. Each wavelength converting member 103a, 103b, 103c, together with its respective diffusive layer 106a, 106b, 106c, forms an acoustic, wavelength converting panel.

Fig. 12b illustrates how the light emitting arrangement of Fig. 12a can be employed as a ceiling, with the diffusive layers 106a, 106b, 106c of the acoustic wavelength converting panels facing towards a room.

The person skilled in the art realizes that the present invention by no means is limited to the preferred embodiments described above. On the contrary, many modifications and variations are possible within the scope of the appended claims. For example, any suitable number or type of solid state light source may be used, and the light source(s) may be located at any position in a light emitting arrangement or a luminaire, such as on one or more sides of the frame 131 or on a surface of the support member 142 perpendicular to the carrier 141.

Additionally, variations to the disclosed embodiments can be understood and effected by the skilled person in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage.

## Claims

1. A wavelength converting member (103) comprising a wavelength converting material (105), capable of converting light of a first wavelength range into light of a second wavelength range, said wavelength converting material being dispersed in an acoustic material (104).

2. A wavelength converting member according to claim 1, wherein said wavelength converting material is contained within a layer of acoustic material.

3. A wavelength converting member according to claim 1, wherein said acoustic material is capable of absorbing acoustic waves.

4. A wavelength converting member according to claim 1, wherein said acoustic material is porous.

5. A wavelength converting member according to claim 1, wherein said acoustic material is selected from chalk, acoustic foams, natural mineral fibers, and synthetic mineral fibers.

6. An acoustic panel (120) comprising a wavelength converting member according to claim 1.

7. A light emitting arrangement (100, 120, 140) comprising:
- a solid state light source (101) adapted to emit light of a first wavelength range; and
- a wavelength converting member (103) according to claim 1 arranged to receive light of said first wavelength range emitted by the light source.

8. A light emitting arrangement according to claim 7, wherein said solid state light source and the wavelength converting material are mutually spaced apart.

9. A light emitting arrangement according to claim 7, further comprising a diffusive layer (106) arranged in the light output direction from the wavelength converting member.

10. A light emitting arrangement according to claim 7, wherein said solid state light source is covered by the acoustic material.

11. A light emitting arrangement according to claim 7, wherein said wavelength converting member forms a panel and said solid state light source is arranged on an external surface of said panel.

12. A light emitting arrangement according to claim 7, wherein said wavelength converting member forms a panel or a part of a panel, and said solid state light source is adapted to be suspended in front of said panel to emit light in the direction of the panel.

13. Use of a wavelength converting member (103) according to claim 1 or a light emitting arrangement (100, 120) according to claim 7 as a building material.

14. A luminaire (130) comprising a light emitting arrangement (100) according to claim 7.

15. A luminaire according to claim 15, comprising a frame (131) and wherein at least one solid state light source (101) is arranged on an inner surface of said frame.
